# FASCICULE DE BREVET EUROPEEN

(11) **EP 0 449 729 B1**
(45) Date de publication et mention de la délivrance du brevet: **02.11.1994**
(21) Numéro de dépôt: 91400827.1
(22) Date de dépôt: 27.03.1991
(51) Int. Cl.: H01C 3/12, H01C 1/14, H01C 1/022

(54) **Résistance de puissance plate**
Flacher Leistungswiderstand
Flat power resistance

(30) Priorité: 28.03.1990 FR 9003946
(43) Date de publication de la demande: 02.10.1991
(73) Titulaire: DAV, F-74106 Annemasse Cédex (FR)
(72) Inventeur: Saulgeot, Jean-Michel, F-74380 Lucinges (FR); Pittion, F-74890 Bons en Chablais (FR)
(74) Mandataire: Levy, David

(56) Documents cités:
- DE-A- 1 540 067
- DE-A- 2 904 197
- DE-A- 3 333 001
- DE-A- 3 741 525
- FR-A- 2 357 906
- US-A- 3 453 585
- US-A- 3 497 859
- PATENT ABSTRACTS OF JAPAN vol. 11, no. 4 (E-468)(2451) 07 janvier 1987 & JP-A-61 180589

## Description

La présente invention concerne une résistance de puissance ou résistance de shunt.

Un secteur technique dans lequel les résistances shunt sont largement utilisées est celui des platines électriques de puissance et, notamment, les dispositifs de test de lampes sur véhicules. Dans une telle utilisation, la résistance shunt, soudée sur le circuit, est utilisée généralement en série avec une charge de puissance, et permet de connaître l'intensité du courant qui circule par la mesure de la chute de tension à ses bornes.

Il y a trois types de résistance shunt actuellement utilisés.

Le premier et le plus ancien consiste en un composant électronique à bornes axiales ou radiales que l'on replie pour un montage en surface. Le volume occupé par ce composant électronique, constitué par un corps cylindrique, est très important et n'est plus adapté dans les circuits miniaturisés, de plus en plus réalisés en vue de constituer des ensembles compacts et de faible encombrement.

Le deuxième type est celui qui est par exemple décrit dans FR-A-2 568 684 et qui consiste à effectuer un dépôt de pâte en couche épaisse sur un support plan, la couche épaisse étant, notamment, reliée aux bornes d'un amplificateur opérationnel par des pistes ou fils de connexion. Toutefois, une telle résistance shunt est fort compliquée à réaliser surtout lorsqu'on désire produire en série des résistances de valeurs ohmiques différentes. En effet, la résistance ohmique est définie par les valeurs résistives de la couche épaisse sur le support plan. Dans ces conditions, il faut adapter, à chaque fois, l'épaisseur et/ou la largeur de la couche déposée sur le support plan, pour déterminer la résistance ohmique de la résistance shunt. En conséquence, la résistance ohmique d'une telle résistance shunt est toujours approximative.

Le troisième type consiste en une bande métallique découpée en pont repliée et pourvue de picots de soudure. Une résistance shunt de ce type, bien que constituant un progrès sensible, présente l'inconvénient d'occuper encore trop de place et de ne pas être isolée thermiquement et électriquement des autres composants qui sont situés à proximité. De plus, le positionnement exact pose quelque problème au montage.

D'autres résistances plates sont décrites dans FR-A-2 357 906, DE-A-2 904 197 et DE-A-37 41 525.

Toutefois, les bornes de connexion de telles résistances sont plates et, de par leurs dimensions, nécessitent que des réceptacles ou logements appropriés soient prévus dans les supports sur lesquels sont serties lesdites résistances. En outre, la faible épaisseur des languettes de connexion, qu'elles soient réalisées d'une seule pièce ou rapportées sur la résistance plate, constitue une zone de faiblesse en raison de la possibilité qu'ont les languettes de se replier.

Enfin, aucun moyen n'est prévu pour empêcher la soudure de remonter vers la zone conductrice de la résistance lorsqu'on réalise une soudure à la vague entre les languettes de connexion et le support.

Ces inconvénients sont évités, suivant la présente invention, par les caractéristiques telles que définies dans la revendication 1.

La résistance plate, selon la présente invention, est facile à fabriquer en série tout en présentant des résistances ohmiques précises par la nature du calibre de la résistance et de la puissance dissipée.

Un autre objet de la présente invention est de réaliser une résistance shunt qui soit facile à insérer dans tout circuit électronique et également dans les boîtes d'interconnexion pour circuits imprimés, tout en autorisant la mesure d'une chute de tension aux bornes de la résistance shunt.

Un autre objet de la présente invention est de réaliser une résistance shunt qui est disposée dans un boîtier qui permet la protection de la résistance shunt en évitant que la chaleur dissipée par ladite résistance shunt ne soit transmise aux autres éléments électroniques voisins, et qui isole électriquement ladite résistance shunt.

Un autre objet de la présente invention est de permettre un repérage de couleur ou un marquage éventuel, destinés à différencier les diverses valeurs des résistances shunt.

D'autres objets et caractéristiques ressortiront mieux à la lecture de la description de plusieurs modes de réalisation de résistances shunt selon la présente invention, ainsi que des dessins annexés sur lesquels :

la figure 1 est une vue en perspective à grande échelle, d'une résistance shunt disposée dans un boîtier, selon la présente invention.

La figure 2 est une vue en plan, à grande échelle, du support de la résistance shunt, ledit support constituant une partie du boîtier représenté sur la figure 1.

La figure 3 est une vue en coupe du support suivant III-III de la figure 2.

La figure 4 est une vue en coupe du support suivant IV-IV de la figure 2.

La figure 5 est une vue de dessus du support représenté sur la figure 2.

La figure 6 est une vue en coupe suivant V-V de la figure 1 du cache.

La figure 7 est une vue suivant VI-VI du cache représenté sur la figure 1.

La figure 8 est une vue en plan d'une résistance shunt selon la présente invention pour une certaine valeur ohmique de ladite résistance.

La figure 9 est une vue partielle en plan d'une bande continue comprenant des résistances shunt de la figure 8.

La figure 10 est une vue en plan d'une résistance shunt selon la présente invention pour une autre valeur ohmique de ladite résistance de la figure 9.

La figure 11 est une vue en plan partielle d'une bande de boîtiers comprenant chacun une résistance shunt.

La figure 12 est une vue en élévation d'un rattache de liaison des boîtiers représentés sur la figure 11.

La figure 13 est une vue partielle en coupe d'une boîte d'interconnexion munie de résistances shunt selon l'invention.

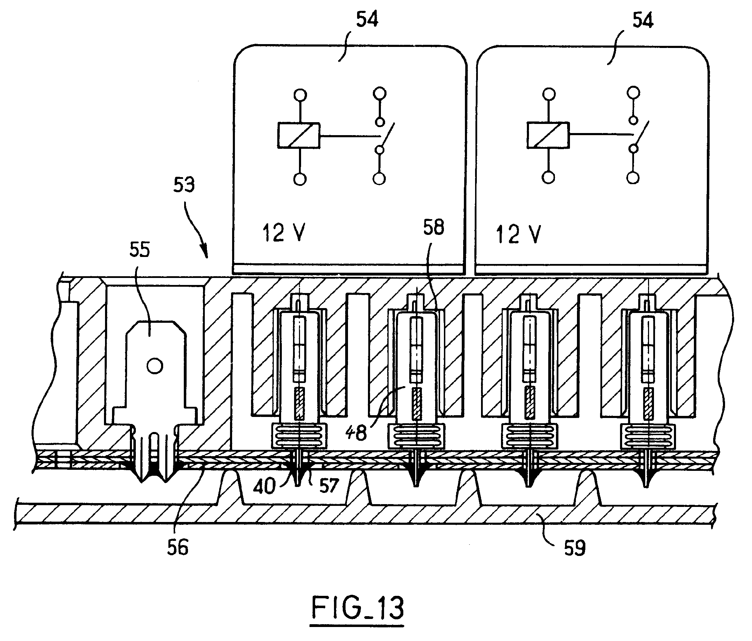

Selon un aspect important de la présente invention, la résistance shunt est disposée dans un boîtier de manière à constituer un composant électronique adapté pour être monté éventuellement dans une boîte d'interconnexion à composants multiples, telle que représentée sur la figure 13.

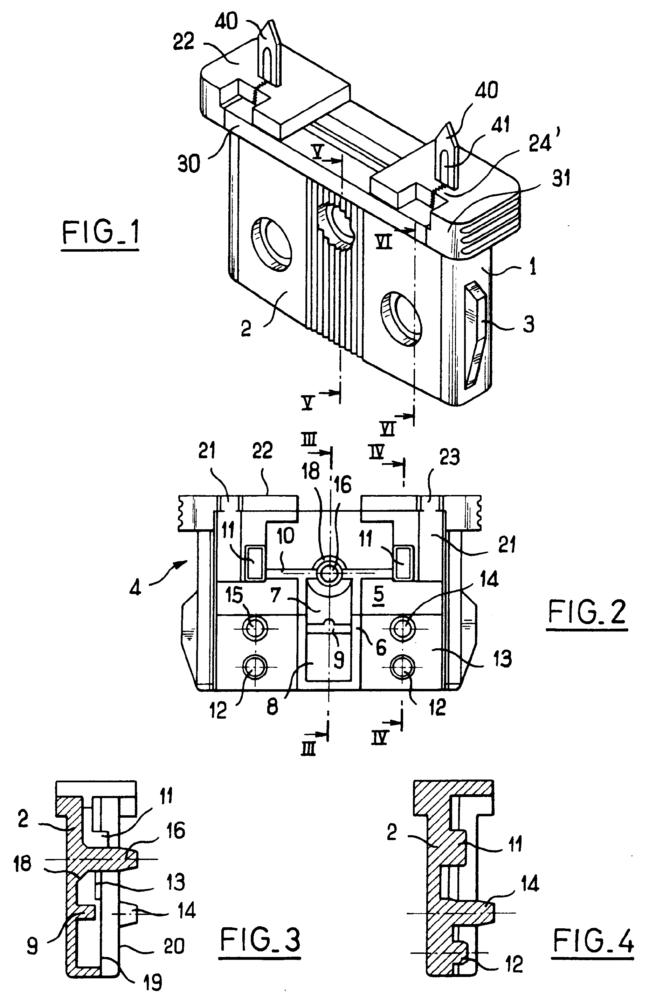

Le boîtier représenté sur la figure 1, comprend deux parties 1 et 2; une première partie 1 constituant un support pour la résistance shunt selon l'invention dont seules les extrémités de contact ou bornes de connexion 40 sont visibles sur la figure 1, et par une deuxième partie ou cache 2. De petits moyens de centrage 3 sont prévus sur les deux côtés latéraux opposés de la partie-support 1 de manière à faciliter le positionnement du boîtier dans une alvéole correspondante de la boîte d'interconnexion.

Le support 4 qui est ouvert sur une des grandes faces latérales, comme cela apparaît sur la figure 2, comprend sur une face fermée 5 opposée à la face ouverte une bordure d'appui 6 sur laquelle vient s'appuyer une surface d'appui du cache 2 lorsque ce dernier est encastré dans le support. La bordure d'appui 6 est de forme rectangulaire et il est ménagé entre ses côtés deux alvéoles 7 et 8 séparées par une nervure de renfort transversale 9. Les alvéoles 7 et 8 permettent d'alléger le support dont la rigidification est obtenue au moyen d'une nervure de renfort transversale 10. Des surépaisseurs locales 11 ménagées aux extrémités de la nervure de renfort 10 contribuent au positionnement de la résistance shunt lors de son montage et servent également d'appui au cache 2.

Deux tétons 12 pour l'accrochage et la fixation de la résistance shunt sont venus de moulage sur une surépaisseur 13 ménagée à la partie inférieure de la face 5 du support 1 et servant également de face d'appui pour la résistance shunt.

Trois tétons de sertissage 14 à 16 disposés en triangle sont également venus de moulage sur la face 5, deux d'entre eux 14 et 15 étant disposés au-dessus des tétons d'accrochage 12 et sur la surépaisseur 13, tandis que le troisième téton 16 est prévu sensiblement au milieu de la nervure de renfort 10. Le téton 10 est prévu au sommet d'un cône de renfort 18. Les faces supérieures de la nervure 10 et de la bordure d'appui 6 sont situées dans un même plan 19 qui est différent du plan 20 contenant les extrémités libres des tétons d'accrochage 12. De façon concrète, la longueur des tétons d'accrochage 12 est plus grande que la hauteur de la bordure d'appui 6 lorsqu'on regarde la figure 3. De même, la longueur des tétons de sertissage 14 à 16 est plus grande que celle des tétons d'accrochage 12, comme cela est visible sur la figure 4.

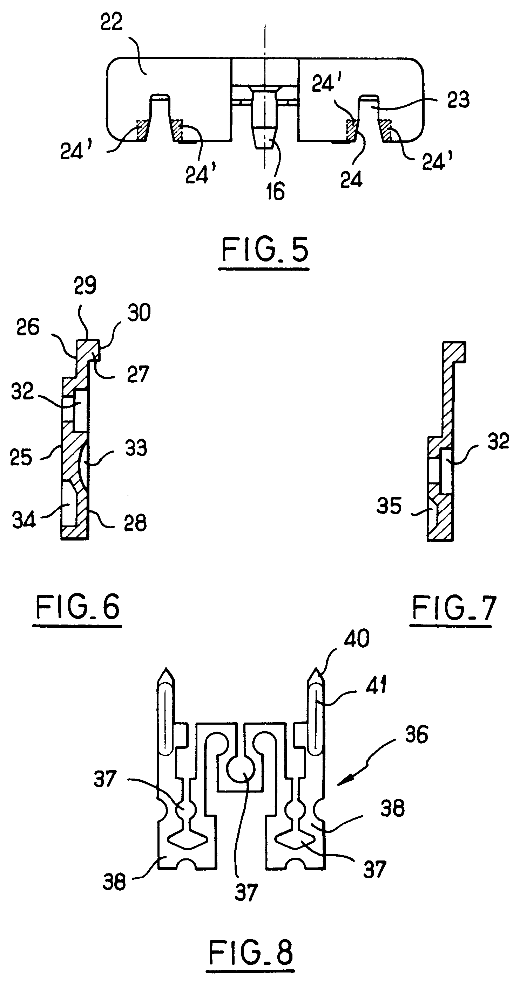

Deux passages 21 pour le positionnement et le maintien des bornes à souder 40 de la résistance shunt, sont ménagés sur la face 5 du support 4 et sont retrécies légèrement en 23 à la traversée d'une bordure supérieure 22 du support. Les traversées rétrécies 23 présentent un chamfrein intérieur et sur la bordure 22, comme cela est visible sur la figure 5, une forme biseautée avec une partie 24 ouvert en V. Une telle forme biseautée facilite la mise en place des bornes à souder 40 de la résistance shunt dans le support 4.

Avec un outil approprié, on découpe une partie 24′ de matière, représentée hachurée sur la figure 5, qui est ensuite repliée vers l'intérieur de manière à venir en appui sur les bornes à souder 40 après mise en place de ces dernières sur le support 4. La matière ainsi rabattue, représentée schématiquement sur la figure 1, permet notamment d'accroître la résistance à la traction latérale des bornes à souder 40 mais surtout d'empêcher une remontée de l'étain lors d'une soudure à la vague desdites bornes sur un support non représenté. Une telle caractéristique présente l'avantage d'éviter des variations de la résistance ohmique du shunt après soudure. En effet, si de l'étain venait malencontreusement à remonter au-delà des bornes à souder, la résistance ohmique s'en trouverait modifiée et les caractéristiques électriques telles que le calibrage de la résistance ne seraient plus respectées.

D'autres moyens pour empêcher la remontée de la matière de soudure peuvent être envisagés, par exemple sur le cache 2 en prévoyant notamment des projections qui s'inséreraient dans le support 4 et seraient en contact avec les bornes à souder 40.

Le cache 2 comprend, figure 6, une surface d'appui 25 ménagée sur la face interne 26 et un rebord externe 27 ménagé sur la face externe 28 du cache, le long du bord supérieur 29 de façon que lorsque le cache 2 est encastré dans le support 4 comme cela est représenté sur la figure 1, on obtienne une continuité, c'est-à-dire que la face externe 30 du rebord 27 soit située dans le même plan que la face externe 31 de la bordure supérieure 22 du support 4. La forme du cache 2 est complémentaire de celle du support 4 et le rebord externe 27 sert pour la tenue dudit boîtier de résistance à l'aide d'une pince d'insertion.

Le cache 2 peut être coloré de manière à distinguer les résistances shunt d'une valeur à l'autre. C'est ainsi que le calibre d'une résistance shunt d'une valeur ohmique de 100 m Ω peut avoir un cache de couleur verte et être différenciée du calibre d'une résistance shunt d'une autre valeur ohmique telle que 25 mΩ en attribuant à cette dernière une autre couleur, jaune par exemple.

Les tétons de sertissage 14 et 15 traversent également des orifices 32 ménagés dans le cache 2 (figures 1 et 7) de manière à permettre de contenir la zone de sertissage desdits tétons lors de la fixation dudit cache 2 sur ledit support 4. Une alvéole borgne 33 est ménagée sur la face externe du cache 2 pour permettre l'entraînement de la bande de résistances plates terminées.

Sur la face interne du cache 2 sont prévues une grande alvéole 34 et deux petites alvéoles 35, l'alvéole 34 étant prévue pour alléger le cache 2 tandis que les alvéoles 35 sont destinés à recevoir les extrémités serties des tétons d'accrochage (figure 7).

Le support 4 et le cache 2 sont réalisés dans une matière plastique opaque, du polyamide par exemple, colorée dans sa masse et chargée à environ 15 % à 30 % de fibre de verre.

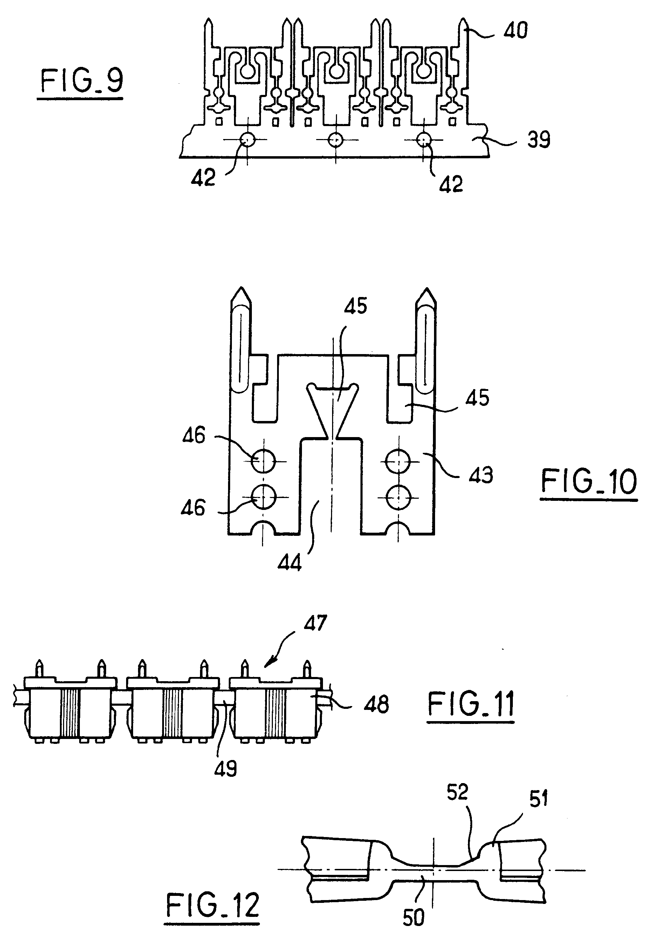

Selon un mode de réalisation de la résistance shunt 36, selon un aspect de l'invention, cette dernière est réalisée à partir d'une bande métallique continue, d'épaisseur sensiblement constante, dans laquelle on ménage des découpes 37 qui délimitent une partie de matière calibrante ou zone 38 présentant une configuration adaptée à la valeur résistive de la résistance et à la puissance dissipée et qui tiennent en compte notamment l'intensité du courant traversant ladite résistance shunt. La résistance shunt 36 représentée sur la figure 8 est une résistance de 100 m Ω . La bande 39 (figure 9), dans laquelle sont réalisées les résistances de la figure 8 présente une dureté 225 HV et une résistivité égale à 50,2 X 10⁻⁸ Ω /m. L'épaisseur est comprise entre 0,1 et 1 mm et elle est ajustée en fonction de la résistivité. Dans l'exemple de la figure 8, l'épaisseur est de 0,3 ⁺ 0,035 mm, et la largeur est d'environ 25 mm avec une résistance ohmique par mètre de bande de l'ordre de 66,9 m Ω ⁺ 5 % .

Par ailleurs, la nature du matériau est sélectionnée pour avoir un coefficient thermique de résistivité très faible (4.10⁻⁵) afin que la chute de tension ne varie pas lorsque la résistance s'échauffe, et un point de fusion élevé, de l'ordre de 2 250°C. Un exemple de métal utilisé pour la fabrication des résistances shunt est une composition de cuivre et nickel dont les proportions approximatives sont de l'ordre de 53 % et 45 % respectivement. De préférence, on n'utilise pas de zinc dans la composition.

La résistance shunt 36 est munie de bornes à souder 40 renforcées et aptes à supporter au moins des efforts perpendiculaires à la surface métallique de dissipation ou zone 38, lesdites bornes étant réalisées d'une seule pièce avec ladite surface de dissipation. Le renfort peut être obtenu notamment par emboutissage de manière à créer des nervures de renfort en forme de V 41 telles qu'elles sont représentées sur la figure 8. Les bornes à souder sont pointues de manière à être logées dans des orifices ou même à créer elles mêmes leur passage à travers le circuit 56 sur lequel elles doivent être soudées. La bande 39 est partiellement étamée avant découpe et elle est munie de trous pilotes 42 pour permettre le déplacement et le positionnement dans un poste de découpe, non représenté. L'étamage est effectué dans la partie de bande correspondant aux bornes à souder. Lorsque les découpes 37 sont effectuées, la bande 39 est amenée à un autre poste qui positionne lesdites résistances sur les supports 4 qui sont également fabriquées en continu suivant un chapelet de supports, chaque résistance étant amenée au-dessus et sertie sur un support 4.

Une autre forme de résistance shunt est représentée sur la figure 10, et qui comprend une plus grande surface métallique de zone 43 dissipative car les découpes ou parties vides sont constituées par une grande échancrure 44 et découpes 45, les orifices 46 servant au sertissage de la résistance sur le support 4.

Les résistances shunt dans leurs boîtiers terminés avec éventuellement un cache coloré, se présentent sous la forme d'un chapelet 47 comme cela est représenté sur la figure 11, chaque boîtier 48 étant relié au précédent par une rattache souple 49. Les rattaches 49, figure 12, comportent une partie centrale 50 amincie permettant un enroulement souple du chapelet sur lui-même, et deux zones de raccordement 51 aux boîtiers adjacents 48, qui sont chamfreinées ou biseautées en 52 sur au moins un des côtés de manière à procurer à la rattache une bonne tenue tout en permettant un sectionnement aisé de ladite rattache lors de la séparation des boîtiers 48 entre eux.

On voit donc que le calibrage de la résistance et de la puissance dissipée sont maîtrisés par ajustage de l'épaisseur de la bande, de sa résistance, de la surface et du profil des découpes.

Sur la figure 13 est représentée schématiquement en coupe, une partie d'une boîte d'interconnexion 53 susceptible de recevoir une ou plusieurs résistances shunt selon l'invention, ainsi que d'autres composants électriques tels que des relais 54 et des fusibles non représentés. Les résistances shunt 36 dans leur boîtier 48 sont disposées dans des logements 58 et sont soudées par leurs bornes à souder 40, au même titre que d'autres composants électriques tels que languette de connexion 55, à un circuit électrique 56 disposé dans le boîtier d'interconnexion. La soudure 57 notamment des résistances shunt est effectuée par une opération dite de soudure à la vague, avant fermeture de la boîte d'interconnexion au moyen d'un couvercle 59.

## Revendications

1. Résistance de puissance plate, du type constituée par au moins un élément conducteur (36) découpé dans une bande continue (39) de matière conductrice suivant un contour qui est fonction de la résistance électrique et/ou de la puissance dissipée que chaque élément conducteur doit présenter, le ou les éléments conducteurs étant chacun disposé dans un boîtier de protection (48) et de préhension et comportant des bornes à souder (40), caractérisée en ce que les bornes à souder (40) sont renforcées au moyen d'une nervure de renforcement (41) et en ce qu'une partie du boîtier (4) comprend des moyens (24′) susceptibles de faire obstacle à une remontée de la matière de soudure le long des bornes à souder (40) lors de la soudure de ladite résistance (36) sur un circuit électrique (56).

2. Résistance de puissance selon la revendication 1, caractérisée en ce que les moyens (24′) formant obstacle sont réalisés par découpe et rabattement de la matière constituant le boîtier (1,2).

3. Résistance de puissance selon la revendication 1, caractérisée en ce que le rabattement de matière est réalisé dans une partie du boîtier constituant un support (4) pour l'élément conducteur.

4. Résistance de puissance selon l'une des revendication 1 à 3, caractérisée en ce que la bande continue (38) est en métal, le boîtier de protection (48) est fermé et il est constitué en deux parties distinctes (1,2) dont une de support pourvue de tétons de sertissage (14,16) traversant des orifices ménagés dans l'élément métallique et l'autre partie de boîtier formant cache (2), de manière à maintenir fixes ledit cache (2) et ledit élément métallique (36) sur ladite partie support (4).

5. Résistance de puissance selon la revendication 2, caractérisée en ce que les moyens formant obstacle (24′) sont constitués par de la matière du boîtier rabattue vers les bornes à souder (40).

6. Résistance de puissance selon l'une des revendications 1 à 5, caractérisée en ce que des rattaches latérales (49) sont prévues sur les boîtiers, de manière à réaliser un chapelet de résistances susceptibles d'être mises en rouleaux comportant un très grand nombre de résistances plates.

7. Résistance de puissance selon la revendication 1, caractérisée en ce que les bornes à souder (40) sont renforcées au moyen de nervures en V (41) obtenues par emboutissage.

8. Résistance de puissance selon la revendication 1, caractérisée en ce que la bande continue (39) est en métal et l'épaisseur de l'élément métallique est comprise entre 0,1 et 1 mm.

9. Résistance de puissance selon l'une des revendications 1 à 8, caractérisée en ce que le boîtier (1,2) est au moins en partie en polyamide.

10. Résistance de puissance selon l'une des revendications 1 à 8, caractérisée en ce que la bande continue (39) est en métal et présente une résistivité de l'ordre de 50.10⁻⁸ Ω /m avec un coefficient de variation thermique de l'ordre de 4.10⁻⁵.

## Patentansprüche

1. Flacher Leistungswiderstand des Typs, der durch wenigstens ein Leiterelement (36) gebildet ist, das in Form eines ununterbrochenen Bandes (29) aus leitendem Material ausgestanzt ist, wobei die Form des Bandes (39) eine Kontur besitzt, die von dem elektrischen Widerstand und/oder von der Leistungsabgabe abhängt, die jedes Leiterelement besitzen soll, wobei das oder die Leiterelemente jeweils in einem Schutz- und Greifgehäuse (48) angeordnet sind und Lötklemmen (40) aufweisen, dadurch gekennzeichnet, daß die Lötklemmen (40) mittels einer Verstärkungsrippe (41) verstärkt sind und daß ein Teil des Gehäuses (4) Mittel (24′) aufweist, die für ein Aufsteigen des Lötmittels längs der Lötklemmen (40) beim Verlöten des Widerstandes (36) in einer elektrischen Schaltung (56) ein Hindernis bilden können.

2. Leistungswiderstand gemäß Anspruch 1, dadurch gekennzeichnet, daß die ein Hindernis bildenden Mittel (24′) durch Ausschneiden und Umbiegen des das Gehäuse (1, 2) bildenden Materials verwirklicht sind.

3. Leistungswiderstand gemäß Anspruch 1, dadurch gekennzeichnet, daß das Umbiegen des Materials in einem Teil des Gehäuses ausgeführt wird, welches einen Träger (4) für das Leiterelement bildet.

4. Leistungswiderstand gemäß einem der Ansprüche 1 bis 3, dadurch gekennzeichnet, daß das ununterbrochene Band (38) aus Metall ist, das Schutzgehäuse (48) verschlossen und aus zwei verschiedenen Teilen (1, 2) gebildet ist, wovon einer als Träger dient, der mit Verbindungszapfen (14, 16) versehen ist, die durch im metallischen Element ausgebildete Öffnungen verlaufen, und der andere Gehäuseteil eine Abdeckung (2) bildet, so daß die Abdeckung (2) und das metallische Element (36) auf dem Trägerteil (4) festgehalten werden.

5. Leistungswiderstand gemäß Anspruch 2, dadurch gekennzeichnet, daß die das Hindernis (24′) bildenden Mittel durch das Material des Gehäuses gebildet sind, das zu den Lötklemmen (40) umgebogen ist.

6. Leistungswiderstand gemäß einem der Ansprüche 1 bis 5, dadurch gekennzeichnet, daß an den Gehäusen seitliche Verbindungsansätze vorgesehen sind, um eine Kette von Widerständen zu verwirklichen, die zu Rollen geformt werden können, die eine sehr große Anzahl von flachen Widerständen enthalten.

7. Leistungswiderstand gemäß Anspruch 1, dadurch gekennzeichnet, daß die Lötklemmen (40) mittels V-Rippen verstärkt sind, die durch einen Ziehvorgang erhalten werden.

8. Leistungswiderstand gemäß Anspruch 1, dadurch gekennzeichnet, daß das ununterbrochene Band (39) aus Metall ist und die Dicke des metallischen Elements im Bereich von 0,1 bis 1 mm liegt.

9. Leistungswiderstand gemäß einem der Ansprüche 1 bis 8, dadurch gekennzeichnet, daß das Gehäuse (1, 2) wenigstens teilweise aus Polyamid ist.

10. Leistungswiderstand gemäß einem der Ansprüche 1 bis 8, dadurch gekennzeichnet, daß das ununterbrochene Band (39) aus Metall ist und einen spezifischen Widerstand in der Größenordnung von 50 · 10⁻⁸ Ω/m mit einem Wärmeveränderungskoeffizienten in der Größenordnung von 4 · 10⁻⁵ aufweist.

## Claims

1. Flat power resistance of the type constituted by at least one conductor element (36) formed in a continuous band (39) of conductive material and following a contour which is a function of the electrical resistance and/or of the power dissipated which each conductor element exhibits, the conductor element or elements each being disposed in an attachment and protection case and including solder terminals (40), characterised in that the solder terminals (40) are re-enforced centrally by a strengthening rib (41) and in that a part of the case (4) includes means (24′) adapted to prevent flow of solder material along the soldering terminals (40) during soldering of said resistance (36) onto an electric circuit (56).

2. Power resistance according to Claim 1, characterised in that the flow preventing means (24′) are formed by cutting and folding the material making up the case (1,2).

3. Power resistance according to Claim 1, characterised in that folding of material is effected in a part of the case constituting a support (4) for the conductor element.

4. Power resistance according to any one of Claims 1-3, characterised in that continuous band (38) is formed of metal, the protection case (48) is closed and is made up of two distinct parts (1,2) one of which being a support and provided with insert stops (14,16) crossing openings formed in the metallic element and the other part of the case forming a mask (2) such as to maintain said mask (2) and the metallic element (36) fixed to said support part (4).

5. Power resistance according to Claim 2, characterised in that the preventing means (24′) are constituted by the box material being folded towards the solder terminals (40).

6. Power resistance according to any one of Claims 1-5, characterised in that lateral connectors (49) are provided in the cases, such as to form an array of resistances adapted to be arranged in a spool comprising a large number of flat resistances.

7. Power resistance according to Claim 1, characterised in that solder terminals (40) are re-enforced centrally by v-shaped ribs (41) formed by stamping.

8. Power resistance according to Claim 1, characterised in that the continuous band (39) is formed of metal and the thickness of the metallic element is between 0.1mm and 1.0mm.

9. Power resistance according to any one of Claims 1-8, characterised in that the case (1,2) is at least partly formed of polyamide.

10. Power resistance according to any one of Claims 1-8, characterised in that the continuous band (39) is formed of metal and has a resistivity of the order of 50.10⁻⁸ Ω/m with a coefficient of thermal expansion of the order of 4.10⁻⁵.
